# EUROPÄISCHE PATENTANMELDUNG

(11) **EP 0 655 881 A1**
(43) Veröffentlichungstag der Anmeldung: **31.05.1995**
(21) Anmeldenummer: 94117697.6
(22) Anmeldetag: 09.11.1994
(51) Int. Cl.: H05K 7/14, H02M 7/00

(54) **Gehäuse**

(30) Priorität: 26.11.1993 DE 4340244
(71) Anmelder: SIEMENS AKTIENGESELLSCHAFT, D-80333 München (DE)
(72) Erfinder: Hecht, Franz, Dipl.-Ing. (FH), D-91074 Herzogenaurach (DE); Kranz, Hans-Werner, Dipl.-Ing., D-91083 Baiersdorf (DE); Hentschel, Mona, Dipl.-Ing., D-91085 Weisendorf (DE); Schinn, Volker, Dipl.-Ing., D-91352 Hallerndorf (DE); Kurze, Bernd, Dipl.-Ing., D-91056 Erlangen (DE); Weichselbaum, Thomas, D-90471 Nürnberg (DE)

(57) **Zusammenfassung**

Die Erfindung bezieht sich auf ein Gehäuse zur Aufnahme einer mit wärmeerzeugenden Bauelementen (92, 98) versehenen Steuereinrichtung (66). Erfindungsgemäß besteht das Gehäuse aus einem Druckguß-Gehäuse, das eine Seitenwand (4), eine Rückwand (6), einen Boden (8), einen Deckel (10), eine vordere Strebe (12), einen Kühlkörper (16) und eine Luftführungseinrichtung (18) umfaßt, einer Abedeckplatte und einer Frontabdeckung, wobei die räumlich parallel zur Rückwand (16) verlaufenden Kühlrippen (14) des Kühlkörpers in der Ebene der Seitenwand (4) enden und mit einem Schottblech (28) abgedeckt sind, wobei der Boden (8) und der Deckel (10) jeweils Durchbrüche (50) zur Entwärmung der vorderen Gehäusehälfte und einen Durchbruch (48) zur Durchführung von Anschlußleitungen versehen sind und wobei die vordere Strebe (12) als seitliches Rahmenteil für die eine seitliche Zugangsöffnung (2) des Gehäuses abdeckende Abdeckplatte und die eine frontseitige Öffnung des Gehäuses verschließbare Frontabdeckung ausgebildet ist. Somit erhält man ein Gehäuse für eine Steuereinrichtung (66) in Book-Size-Format, wobei sich die Anzahl der Montageteile, der Montageaufwand und die Montagezeit wesentlich verringern.

## Beschreibung

Die Erfindung bezieht sich auf ein Gehäuse zur Aufnahme einer Mit wärmeerzeugenden Bauelementen versehenen Steuereinrichtung.

Bei der Steuereinrichtung kann es sich beispielsweise um ein Invertergerät, eine Umkehrstufe, einen Wechselrichter oder eine sonstige Steuereinrichtung handeln, die elektrische bzw. elektronische Elemente umfaßt.

Aus der deutschen Patentschrift 34 12 510 ist ein Aluminium-Druckguß-Gehäuse bekannt, das eine Rückwand und zwei Seitenwände umfaßt. Die Rückwand ist mit Kühlrippen versehen, wobei ein Kühlgebläse oder ein Kühlventilator an der Unterseite des Gehäuses angebracht ist. In den Außenwänden des Gehäuses sind an der Oberseite und der Unterseite des Gehäuses Wegbrechungen oder Aussparungen ausgebildet, die zur Aufnahme von austauschbaren Gehäusewänden vorgesehen sind, die mit Aussparungen und Durchführungen für Anschlußkabel versehen sind. Die im Innenraum befindliche, aufgeheizte Luft steigt aufgrund der Konvexion nach oben und tritt durch die oberen Aussparungen aus, während äußere Luft durch die unteren Aussparungen eintritt. Die elektrischen Bauelemente, beispielsweise Dioden und Transistormoduln, gehören zu der Steuereinrichtung und sind in gutem wärmeleitenden Kontakt mit der Rückwand, die auf seiner Außenseite Kühlrippen aufweist, angebracht. Eine gedruckte Schaltungsplatte oder Leiterplatte, auf der elektronische Bauteile für die Steuereinrichtung montiert sind, ist lösbar im Gehäuse angebracht. Die Seitenwände sind derart ausgestaltet, daß sie die Kühlrippen seitwärts einschließen und das Gehäuse auf einem Tragblech montiert werden kann, wodurch geschlossene Kühlkanäle entstehen. Die lösbare Abdeckplatte ist aus Kunststoff und dichtet das Gehäuse vollständig ab, wenn die Steuereinrichtung im Gehäuse zusammengebaut und verdrahtet ist.

Aus der europäischen Patentanmeldung 0 356 991 ist ein Invertergerät bekannt, das aus einem zweiteiligen Gehäuse besteht, nämlich einem unteren und einem oberen Kasten. Der untere Kasten besteht aus Aluminium-Druckguß mit Kühlrippen an einer Außenseite, wobei die Kühlrippen seitwärts eingeschlossen sind und ein Kühlgebläse an der Unterseite dieses unteren Kastens angebracht ist. Die offenen Kühlkanäle, gebildet durch die Kühlrippen, schließen sich, sobald das Invertergerät an einer Montageplatte montiert wird. Auf dem Boden des unteren Kastens sind die wärmeerzeugenden Bauelemente des Invertergerätes montiert. Außerdem weist dieser Boden eine Aufnahmevorrichtung für einen Zwischenkreiskondensator auf, dessen Kondensatoren in den Gebläsestrom hineinragen. Dieser untere Kasten des Gehäuses ist durch eine Abdeckplatte, die als Kühlkörper ausgebildet ist, hermetisch abgeschlossen. Auf diese Abdeckplatte ist eine Steuer- und Regelplatine beabstandet montiert, die mittels Kabel mit den Bauelementen im unteren Kasten elektrisch leitend verbunden ist. Der obere Kasten ist als Deckel ausgebildet, der mit dem unteren Kasten lösbar verbunden ist. In diesem Deckel ist ein Bedienfeld untergebracht. Dieser Deckel besteht aus einem isolierenden Material, beispielsweise Kunststoff.

Aus der europäischen Patentanmeldung 0 449 640 ist eine elektrische Vorrichtung bekannt, die einen Kühlkörper hat, der mehrere Ausnehmungen aufweist. Diese Ausnehmungen zur Aufnahme von elektrischen Bauelementen sind derart ausgestaltet, daß die Anschlüsse dieser Bauelemente alle in einer Ebene liegen und mittels einer gedruckten Leiterplatte miteinander elektrisch leitend verbunden sind. Beabstandet zu dieser Leiterplatte ist eine Steuer- und Regelplatine angebracht. Ein Deckel aus isolierendem Material deckt diese Leiterplatte ab und ist mit dem Kühlkörper lösbar verbunden.

Aus dem Siemens-Prospekt "SIMOVERT PX - Spannungszwischenkreis-Umrichter 6SE60 für dynamische, bürstenlose Antriebe", Bestell-Nr. E20001-P181-A419, sind Gehäuse für Umrichter in der sogenannten Book-Size-Form bekannt, wodurch die Aneinanderreihung mehrerer Gehäuse möglich ist, beispielsweise bei Mehrmotorenantrieben. Bei diesem Gehäuse in Book-Size-Format ist das tragende Element der Kühlkörper. Das Gehäuse ist aus Stahlblech allseitig geschlossen ausgeführt, um eine hohe elektromagnetische Verträglichkeit sicherzustellen. Die Montage dieser Geräte kann problemlos an einer Schrankwand erfolgen. Alle Anschlüsse erfolgen von unten über schraublose Käfigzugfederklemmen. Das Bedienfeld, bestehend aus mehreren Parametriertasten und einem Display, ist in der frontseitigen Schmalseite des Gehäuses untergebracht. Der Kühlkörper an der rückseitigen Schmalseite des Gehäuses weist ein Befestigungsblech auf, das am oberen Ende eine Aufhängevorrichtung und am unteren Ende eine Befestigungseinrichtung aufweist. Dieses Blech verschließt außerdem die offenen Kühlkanäle.

Aus dem Siemens-Prospekt "SIMOVERT PM - Das modulare Umrichtersystem 6SM1 für Mehrmotorenantriebe", Bestell-Nr. E20001-P181-A439, ist ein modulares Umrichtersystem bekannt, das aus einer Einspeiseeinheit, einer Zentralelektronik, einer Gleichspannungs-Zwischenkreisschiene und bis zu sechzehn Wechselrichtereinheiten besteht. Die Wechselrichtermodule haben gleich Höhe und damit gleiches Anschluß- und Befestigungsrastermaß und werden über eine Schnappverbindung an die Gleichspannungsschiene angeschlossen. Die Komponenten der Wechselrichtermodule sind Zwischenkreissicherung, Zwischenkreiskondensatoren und -drossel, Transistor-Pulsumrichter, Ausgangsdrossel, Steuer- und Regelelektronikbaugruppe in einer Elektronikbox mit einem Freiplatz für Optionsbaugruppen, Ventilator, Kühlkörper mit Temperaturüberwachung und Steuerklemmleiste. Tragendes Element ist wieder einmal der Kühlkörper, an dem die Seitenwände befestigt werden. Diese Seitenwände dienen als Tragbleche für die Elektonikbox und der Elektrikbaugruppe, die ein Netzgerät, mehrere Ansteuerbaugruppen, Zwischenkreiskondensatoren und -drosseln, ..., umfaßt. An diesen Teilen (Kühlkörper, Seitenwände) werden noch eine Frontabdeckung, ein Deckel- und Bodenblech lösbar befestigt. Das Boden- und Deckelblech weist Durchbrüche zur Entwärmung des Modulinneren auf.

Bei all diesen Gehäusetypen besteht ein Gehäuse aus mehreren Teilen, die miteinander verbunden werden müssen, wenn Teilkomponenten einer Steuereinrichtung zuvor daran befestigt sind. Dabei dient der Kühlkörper als tragendes Element, auf dem mittels Aufbauteilen (Abstandsstücke, Aufbaubleche) die weiteren Komponenten bzw. Teile einer Steuereinrichtung befestigt werden. Durch eine derartige Aufbautechnik sind einige Komponenten einer eingangs genannten Steuereinrichtung nicht mehr ohne weiteres zugänglich. Außerdem umfaßt die Montage eines derartigen Gehäuses eine Vielzahl von Montageschritten, so daß die Montage sehr aufwendig und zeitintensiv ist.

Der Erfindung liegt nun die Aufgabe zugrunde, ein Gehäuse zur Aufnahme einer Steuereinrichtung anzugeben, wodurch sich der Aufwand und die Zeit bei der Montage erheblich reduziert.

Diese Aufgabe wird erfindungsgemäß gelöst durch die Merkmale des Anspruchs 1.

Dadurch, daß das Druckguß-Gehäuse neben einer Seitenwand, einer Rückwand, einem Boden, einem Deckel und einer vorderen Strebe auch noch einen mit mehreren Kühlrippen versehenen Kühlkörper mit einer Luftführungseinrichtung umfaßt, müssen nur noch zwei Abdeckungen montiert werden, nämlich eine zur Abdeckung einer seitlichen Zugangsöffnung des Gehäuses und eine zur Abdeckung einer frontseitigen Öffnung. Durch diese Ausgestaltung des Druckguß-Gehäuses erhält man eine größere Zugangsöffnung zum Inneren des Gehäuses, wodurch sich die Montage des Komponenten der Steuereinrichtung vereinfacht. Durch die Integration des Kühlkörpers in das hintere Gehäuseteil entsteht eine Zweiteilung des Gehäuses, wodurch zwei unterschiedliche Montage-Ebenen geschaffen werden, so daß man nach der Montage der wärmeerzeugenden Bauelemente auf den Kühlkörper und der Elektronikbox mit einer Steuer- und Regelbaugruppe eine großflächig einheitliche Montagefläche erhält. In dieser Montagefläche wird nur noch eine vormontierte Elektrikbaugruppe, die beispielsweise die Zwischenkreiskondensatoren und -drossel, ein Netzgerät, Relais, Ansteuerbaugruppen, Leistungsanschlußklemmen, ..., aufweist, derart plaziert, daß die Bauelemente dieser Elektrikbaugruppe ins Innere des Gehäuses ragen und die Lötseite dieser Elektronikbaugruppe eine flache Abschlußwand des Gehäuses bildet. Auf diese Abschlußwand braucht nur noch ein Abdeckplatte elektrisch isolierend aufgebracht werden und lösbar mit dem Druckguß-Gehäuse verbunden werden. Selbst für einen Ventilator ist bereits eine Aufnahmevorrichtung im Druckguß-Gehäuse integriert, so daß auch dessen Montage mit wenigen Handgriffen erledigt ist.

Somit verringert sich der Montageaufwand und die Montagezeit bei dem erfindungsgemäßen Gehäuse im Book-Size-Format erheblich, wodurch mittels vormontierter Komponenten der Steuereinrichtung die Endmontage ebenfalls sehr einfach ausfällt.

Die vorteilhaften Ausgestaltungen des erfindungsgemäßen Gehäuses sind den abhängigen Ansprüchen 2 bis 18 zu entnehmen. In diesem Zusammenhang sei auf den separaten Kühlkanal für Konvektionskühlung hingewiesen, in den beispielsweise die Zwischenkreiskondensatoren hineinragen. Es ist auch denkbar, diesen separaten Kühlkanal und den Kühlkörper als einstückige Baueinheit auszubilden, wobei dann auch der Bereich "Kühlkanal" zwangsbelüftet wird.

Durch die Aufhängevorrichtung und die Befestigungseinrichtung kann dieses Gehäuse, das im montierten Zustand ein komplettes Umrichtergerät darstellt, an eine genormte Tragschiene (G-Schiene) einer Schrankrückwand bzw. einer Tragwand angehängt und an diesen angeflanscht werden.

Zur weiteren Erläuterung wird auf die Zeichnung bezug genommen, in der mehrere Ausführungsbeispiele des erfindungsgemäßen Gehäuses schematisch veranschaulicht sind.
- Figur 1: zeigt eine perspektivische Ansicht eines erfindungsgemäßen Gehäuses eines Kompaktgerätes der Baugröße I, die
- Figur 2: zeigt eine zugehörige perspektivische Ansicht des Gehäuses nach Figur 1 von schräg unten, in
- Figur 3: ist ein Übersichtsschaltplan einer Steuereinrichtung (Umrichter), die im Gehäuse nach Figur 1 untergebracht wird, wobei die
- Figur 4: ein teilmontiertes Gerät der Baugröße I nach Figur 1 darstellt, die
- Figur 5: zeigt eine Ausführungsform eines erfindungsgemäßen Gehäuses eines Kompaktgerätes der Baugröße II, wogegen in
- Figur 6: das Gehäuse der Baugröße II nach Figur 5 im teilmontierten Zustand veranschaulicht ist, in
- Figur 7: ist das Gehäuse eines Kompaktgerätes der Baugröße III dargestellt, wogegen die
- Figur 8: das Gehäuse der Baugröße III im teilmontierten Zustand zeigt.

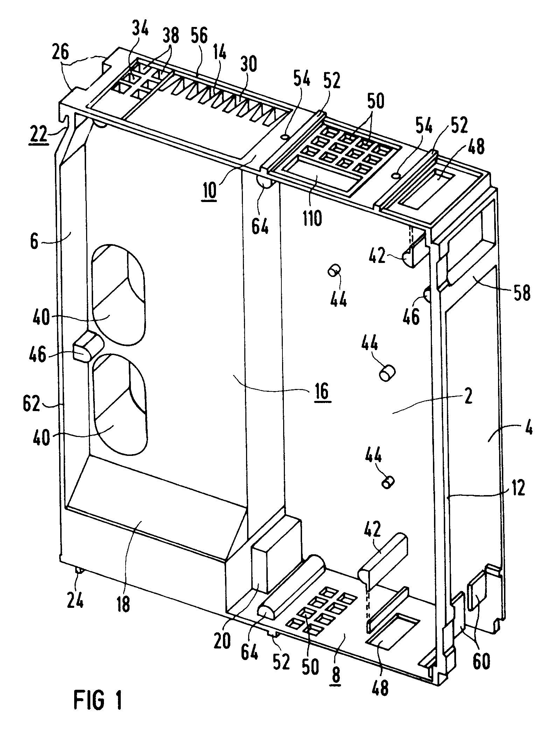

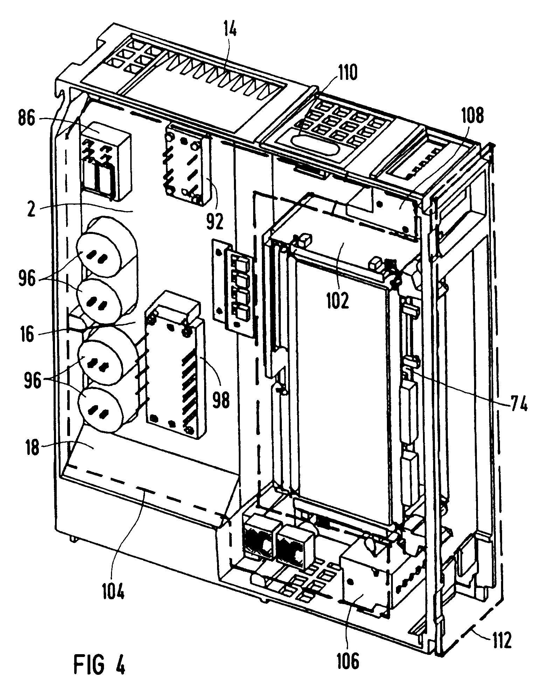

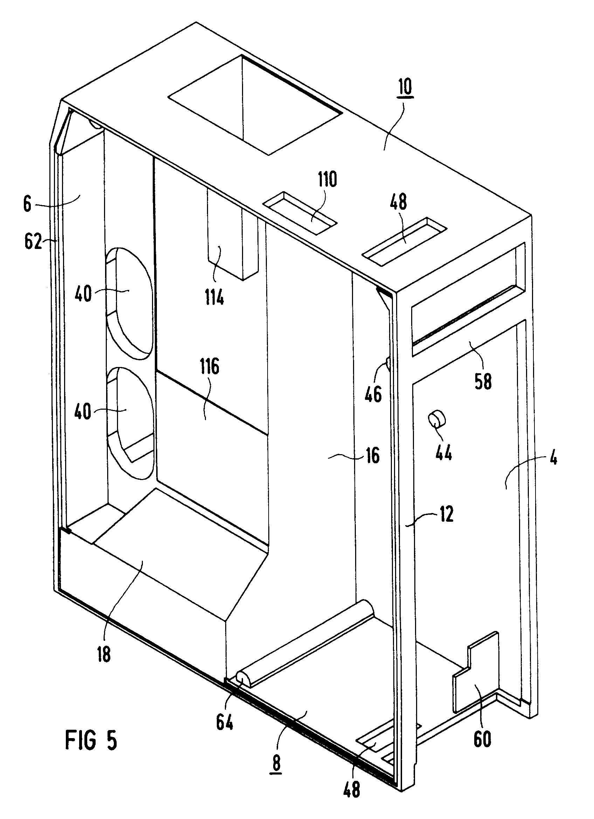

Bei der nun folgenden Beschreibung der mehreren Ausführungsbeispiele des erfindungsgemäßen Gehäuses sind gleiche Elemente mit demselben Bezugszeichen versehen. Um Wiederholungen zu vermeiden, wird bei den Beschreibungen der zweiten und dritten Ausführungsform (Figur 5 bis Figur 8) nur noch auf die Unterschiede zur Ausführungsform gemäß Figur 1 bzw. Figur 4 hingewiesen.

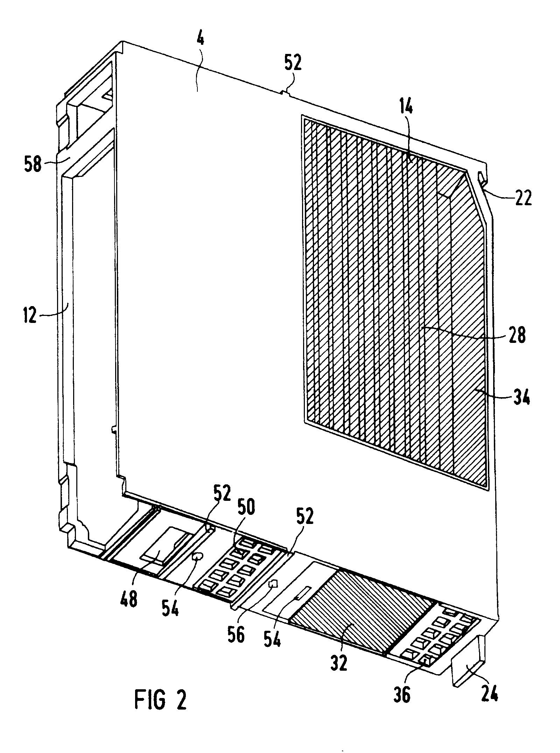

Die Figur 1 zeigt eine perspektivische Ansicht des erfindungsgemäßen Druckguß-Gehäuses von schräg oben, wogegen in der Figur 2 eine perspektivische Ansicht von schräg unten dargestellt ist. In der Darstellung nach Figur 1 ist eine Abdeckplatte, die eine seitliche Zugangsöffnung 2 des Gehäuses verschließt, und eine Frontabdeckung, die eine Bedieneinheit, bestehend aus mehreren Parametriertasten und einem Display, aufweist, nicht zu sehen. Das erfindungsgemäße Druckguß-Gehäuse, insbesondere Aluminium-Druckguß-Gehäuse, umfaßt eine Seitenwand 4, eine Rückwand 6, einen Boden 8, einen Deckel 10, eine vordere Strebe 12, einen mit mehreren Kühlrippen 14 versehenen Kühlkörper 16, eine Luftführungseinrichtung 18 und eine Ausformung 20. Als Material für dieses Druckguß-Gehäuse wird eine Aluminium-Legierung, beispielsweise AlSi 12, verwendet.

Die Rückwand 6 des Gehäuses ist im oberen Teil mit einer Aufhängevorrichtung 22 und im unteren Teil mit einer Befestigungseinrichtung 24 versehen. Dabei sind die Aufhängevorrichtung 22 und die Befestigungseinrichtung 24 integraler Bestandteil der Rückwand 6. Die Aufhängevorrichtung 22 ist derart ausgestaltet, daß deren Haken 26 in Flucht zur Rückwand 6 liegen. Als Befestigungseinrichtung 24 ist eine Anflanschung vorgesehen. Mittels der Aufhängevorrichtung 22 kann das Gerät (Gehäuse mit einer Steuereinrichtung) an einer genormten Tragschiene, beispielsweise einer G-Schiene, aufgehängt werden. Mittels der Befestigungseinrichtung 24 kann das aufgehängte Gerät an eine ebene Fläche, beispielsweise eine Schrankrückwand bzw. ein Tragblech, lösbar befestigt werden.

Der Kühlkörper 16 ist im hinteren Teil des Gehäuses derart angeordnet, daß deren Kühlrippen 14 räumlich parallel zur Rückwand 6 zwischen dem Deckel 10 und der Luftführungseinrichtung 18 verlaufen. Die Höhe des Kühlkörpers 16 entspricht etwa der Hälfte bis zwei Drittel der Breite des Gehäuses. Bei der Gestaltung des Kühlkörpers 16 werden die Abmessungen der wärmeerzeugenden Bauelemente (Dioden, Transistoren, ...) berücksichtigt. Die Kühlrippen 14 enden in der Ebene der Seitenwand 4 und sind mittels eines Schottblechs 28 (Figur 2) abgedeckt, so daß stirnseitig offene Kühlkanäle 30 entstehen, durch denen mittels eines Lüfterventilators Kühlluft zwangsgeführt wird. Ein solcher Lüfterventilator wird im Eingangsbereich der Luftführungseinrichtung 18 angeordnet. Neben dem Eingangsbereich der Luftführungseinrichtung 18 schließt sich die Ausformung 20 an, die einen Steckverbinder aufnimmt. Dadurch kann der Lüfterventilator auch beim montierten Gehäuse installiert werden. Die Luftführungseinrichtung 18 und die Ausnehmung 20 sind mit einer Lüftergitterabdeckung 32 (Figur 2), die mit dem Lüfterventilator verschraubt ist, abgedeckt.

Die Luftführungseinrichtung 18 ist derart ausgestaltet, daß seine Rückseite integraler Bestandteil der Seitenwand 4 des Druckguß-Gehäuses ist. Die Tiefe der Luftführungseinrichtung 18 im Eingangsbereich ist gleich der Breite des Gehäuses und ist quaderförmig. Daran schließt sich ein in der Tiefe begrenzender Raum an, der in den aneinandergereihten stirnseitigen Kühlkanälen 30 mündet. Der Eingangsbereich der Luftführungseinrichtung 18 und die benachbarte Ausformung 20 sind weitgehend voneinander getrennt.

Der Darstellung gemäß Figur 1 kann entnommen werden, daß zwischen dem Kühlkörper 16 und der Rückwand 6 des Druckguß-Gehäuses ein separater Kühlkanal 34 angeordnet ist, bei dem durch Durchbrüche 36 im Boden 8 Kühlluft eintritt und diese dann durch Durchbrüche 38 im Deckel 10 wieder austritt. In Hinblick auf eine einfache Gußform ist dieser separate Kühlkanal 34 zur Seitenwand 4 des Druckguß-Gehäuses offen. Dieser Kühlkanal 34 wird ebenfalls mit einem Schottblech abgedeckt, wobei mittels eines Schottblechs 28 die Kühlkanäle 30 des Kühlkörpers 16 und der separate Kühlkanal 34 gemeinsam abgedeckt werden. In diesem Kühlkanal 34 ragt wenigstens eine Aufnahmevorrichtung 40 für zu kühlende Bauelemente der Steuereinrichtung hinein. Bei diesen Bauelementen handelt es sich beispielsweise um Kondensatoren eines Zwischenkreiskondensators, die mittels Konvektionskühlung gekühlt werden. Falls die Konvektionskühlung nicht ausreicht, kann sich die Luftführungseinrichtung 18 auch noch über den Zugang des separaten Kühlkanals 34 erstrecken, wodurch aus einer Konvektionskühlung dann eine Zwangskühlung wird.

Außerdem erkennt man an dieser Darstellung des Gehäuses nach Figur 1, daß das Gehäuseinnere in zwei Teilen unterteilt ist, nämlich in einen Teil in dem der Kühlkörper 16, der separate Kühlkanal 34 und die Luftführungseinrichtung 18 untergebracht sind und in einem Teil, dem die gesamte Breite des Gehäuses zur Verführung steht. In diesem Raum sind Hilfsmittel, wie Stege 42, Anschlußdome 44 und Sockel 46 vorgesehen, wobei auch im hinteren Teil des Gehäuses ein Sockel 46 angeordnet ist. Die Anschlußdome 44 sind für die Befestigung von Komponenten einer Steuereinrichtung vorgesehen, wobei eine Elektrikbaugruppe dieser Steuereinrichtung mittels der Sockel 46 lösbar mit dem Druckguß-Gehäuse verbunden werden kann. Dabei dienen die Stege 42 als Aufnahmevorrichtung von Leistungsanschlußklemmen, die mit der Elektrikbaugruppe der Steuereinrichtung verbunden sind.

Damit zu diesen Leistungsanschlußklemmen auch Anschlußleitungen hingeführt und angeschlossen werden können, weisen der Boden 8 und der Decekl 10 des Gehäuses in unmittelbarer Nähe dieser Stege 42 jeweils einen Durchbruch 48 auf. Außerdem weisen der Boden 8 und der Deckel 10 im Bereich der vorderen Gehäusehälfte jeweils Durchbrüche 50 zur Entwärmung dieser Gehäusehälfte auf. Damit ein Spritzschutzblech bzw. eine Schirmabdeckung bzw. sogenannte Hutzen (Anschlußtrichter) am Boden 8 bzw. am Deckel 10 befestigt werden können, sind der Boden 8 und der Deckel 10 jeweils mit Anschlagrippen 52 mit zugehörigen Gewindebohrungen 54 bzw. eine Auflageschulter 56 mit zugehöriger Gewindebohrung 54 versehen.

Die vordere Strebe 12 bildet eine vordere linke Kante des Druckguß-Gehäuses und verbindet den Boden 8 und den Deckel 10 miteinander In der durch die vordere Strebe 12 und der Seitenwand 4 gebildeten Öffnung ist im oberen Teil eine Querstrebe 58 eingesetzt und im unteren Teil befinden sich zwei Stege 60, die an der Seitenwand 4 angebracht sind und nach innen versetzt sein können. An diesen Stegen 60 kann ein Leitungsschirm von Steuerleitungen angeschlagen werden. Die vordere Strebe 12 ist ebenfalls so ausgeformt, daß an ihr ein Drehscharnier einer Frontabdeckung befestigt werden kann.

Die Abdeckplatte, die wegen der Übersichtlichkeit weggelassen wurde, liegt im montierten Zustand auf einer durchgehenden Schulter 62 entlang der Zugangsöffnung 2 auf. Die lösbare Befestigung der Seitenabdeckung erfolgt über drei bzw. zwei Befestigungspunkte, die sich auf Auswerferpunkten 64 befinden.

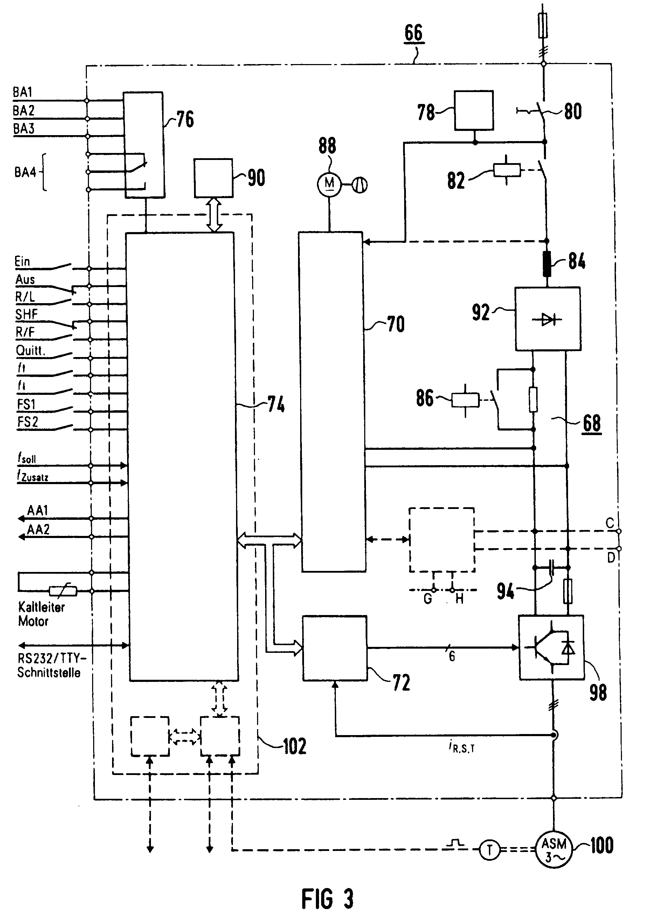

In Figur 3 ist ein Übersichtsschaltplan einer bekannten Steuereinrichtung 66, die im Gehäuse untergebracht wird, schematisch dargestellt. Diese Steuereinrichtung 66 ist im Siemens-Katalog "DA 66.1-1992", insbesondere den Seiten 2/1 bis 2/22 und 2/43 bis 2/57, näher dargestellt und beschrieben. Die Figur 4 zeigt die Komponenten dieser Steuereinrichtung 66 im erfindungsgemäßen Druckguß-Gehäuse. Bei der Steuereinrichtung 66 handelt es sich beispielsweise um einen Umrichter, der einen Leistungsteil 68, eine Stromversorgung 70, eine Ansteuerung 72, eine Steuer- und Regelungsbaugruppe 74, eine Relaisbaugruppe 76, einen Entstörfilter 78, einen Netzschalter 80, eine Netzkommutierungsdrossel 84, ein Vorladerelais 86, einen Ventilator 88 und ein Bedienfeld 90, enthält. Das Leistungsteil 68 besteht aus einem Gleichrichter 92 zur Gleichrichtung der Netzspannung, einer Zwischenkreisdrossel und einem Zwischenkreiskondensator 94, bestehend aus mehreren Kondensatoren 96, beispielsweise vier Kondensatoren 96 (Figur 4), zur Glättung der Zwischenkreisspannung und zur Entkopplung eines Wechselrichters 98 vom Netz.

Bei Umrichtern ab beispielsweise 16 kVA bestehen Eingangsteil und Zwischenkreis aus einer Netzkommutierungsdrossel 84, einem Gleichrichter 92 und dem Zwischenkondensator 94. Bei Umrichtern ab beispielsweise 22 kVA ist der Gleichrichter 92 als halbgesteuerte Brücke aufgebaut, Vorladewiderstand und Vorladerelais 86 entfallen.

Über die Klemmen C und D ist der Zwischenkreis herauszuführen. Damit können zum Energieausgleich zwischen verschiedenen, an gleichen Netz angeschlossenen Umrichtern die Zwischenkreise miteinander verbunden werden.

Die drei Phasen des Wechselrichters 98 sind aus abschaltbaren Stromrichterventilen beispielweise Transistormoduln, IGBT-Moduln mit den zugehörigen Freilaufdioden aufgebaut. Der Wechselrichter 98 erzeugt aus der konstanten Zwischenkreisspannung einen Drehstromsystem mit variabler Frequenz und sinusförmigen Strömen zur Speisung eines angeschlossenen Induktionsmotor 100.

Die Stromversorgung 70 des Umrichters besteht aus einem Schaltnetzteil, das sowohl am Drehstromnetz als auch über Dioden abgekoppelt am Zwischenkreis angeschlossen ist. Dadurch ist eine Pufferung der Stromversorgung aus dem Zwischenkreis möglich.

Über die Ansteuerbaugruppe 72 werden die von der Regelung erzeugten Steuersignale potentialgetrennt in entsprechende Ein/Aus-Befehle für die Transistoren des Wechselrichters 98 umgesetzt. Auf der Steuer- und Regelungsbaugruppe 74, die in einer Elektronikbox 102 untergebracht ist, sind die Funktionen "Ablaufsteuerung und Bedienen", "Feldorientierte Regelung" und "Unterlagerte Phasenstromregelung" zusammengefaßt. Außerdem befindet sich auf diese Baugruppe 74 eine Steuerklemmleiste, eine Schnittstelle zum Bedienfeld und eine Standardschnittstelle.

Die Komponenten 70 - 86 und 96 dieses Umrichters sind auf einer Leiterplatte montiert und bilden eine Elektrikbaugruppe 104, die in der Figur 4 nur durch eine unterbrochene Linie dargestellt wird. Diese Elektrikbaugruppe 104 wird separat vorgefertigt. Diese vorgefertigte Elektrikbaugruppe 104 wird mit der Bauelementeseite in die Zugangsöffnung 2 des Gehäuses gesteckt. Im Druckguß-Gehäuse sind bereits die Leistungskomponenten 92 und 98 und das Vorladerelais 86 auf dem Kühlkörper 16 montiert bzw. bei Stromrichtergeräten kleinerer Leistungen sind auch die Leistungskomponenten 92 und 98 auf der Leiterplatte 104 montiert. Im vorderen Teil des Gehäuses ist ebenfalls schon die Elektronikbox 102 mit der Steuer- und Regelungsbaugruppe 74 montiert. Die Elektrikbaugruppe 104 wird mittels der Kondensatoren 96 und der Leistungsanschlußklemmen 106 und 108 im Gehäuse fixiert und gehalten, so daß diese Baugruppe 104 ohne weitere Zentriereinrichtungen an zwei Punkten (Auswerferpunkten 64) lösbar befestigt werden kann. Damit die Anschlüsse für die externe Stromversorgung und die Hilfsschützansteuerung aus dem Inneren des Gehäuses herausgeführt werden können, ist der Deckel 10 mit einem weiteren Durchbruch 110 versehen. In der Figur 4 ist ebenfalls die Lage der Frontabdeckung mit einer unterbrochenen Linie 112 dargestellt. Durch Wegklappen der Frontabdeckung ist der Zugang zur Elektronikbox 102 frei, so daß weitere Optionsbaugruppen in diese Elektronikbox 102 gesteckt werden können. Die Lötseite der Elektrikbaugruppe 104 wird mit einer Abdeckplatte aus isolierendem Material abgedeckt, bevor die seitliche Abdeckung aus Metall des Gehäuses lösbar mit dem Druckgruß-Gehäuse verschraubt wird.

Die Figur 5 zeigt ein erfindungsgemäßes Druckguß-Gehäuse für ein Kompaktgerät der Baugröße II in eine sehr schematischen Darstellung. Das heißt einige Elemente des Druckguß-Gehäuses, wie z.B. Kühlrippen 14, Durchbrüche 36, 38 und 50 sind in den Figuren 5 bis 8 nicht mehr dargestellt worden, da diese Darstellungen nur dazu dienen, die Unterschiede zum Kompaktgerät der Baugröße I aufzuzeigen. Der Unterschied zum Druckguß-Gehäuse für ein Kompaktgerät der Baugröße I gemäß Figur 1 besteht darin, daß zunächst die Breite des Gerätes viel größer ist. Ebenso ist die Seitenwand 4 an der vorderen Kante mit einer Verstärkungsstrebe, auch Versteifung genannt, versehen. Der Kühlkörper 16 ist für das Leistungshalbleitermodul des Gleichrichters 92 mit einem Sockel 114 und für das Leistungshalbleitermodul des Wechselrichters 98 mit einer kleinen Erhöhung 116 versehen. Dieser Sockel 114 und die Erhöhung 116 dienen als Abstandsausgleichseinrichtung, womit der Abstand zwischen dem mit der Elektrikbaugruppe 104 elektrisch leitend verbundenen Modul und dem Kühlkörper 16 ausgeglichen wird.

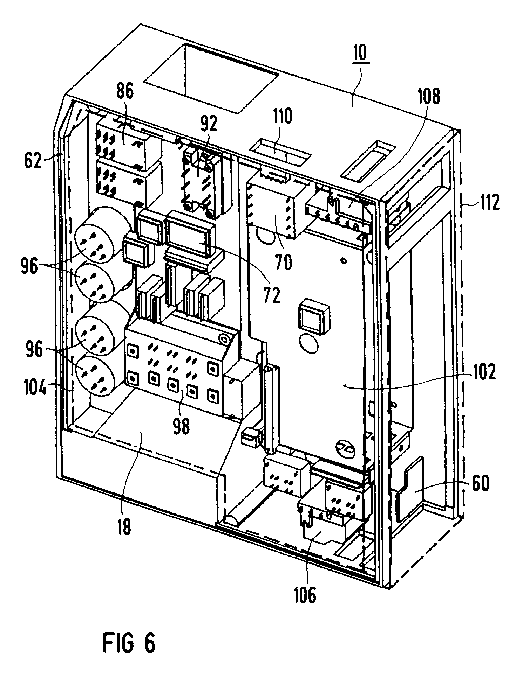

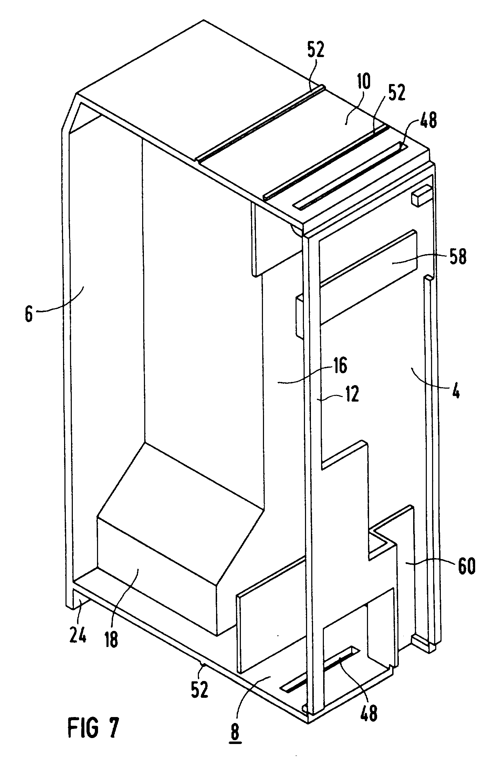

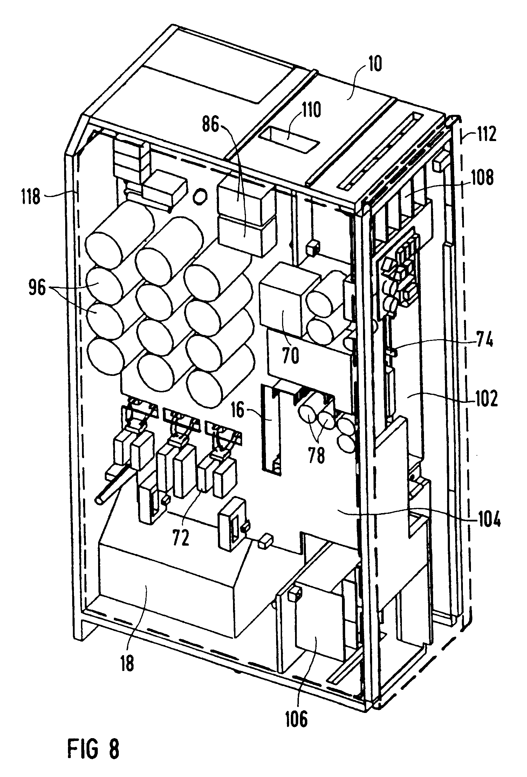

Der Figur 6 kann entnommen werden, daß die Baugröße II des Kompaktgerätes für eine höhere Leistungsklasse vorgesehen ist, da die einzelnen Komponenten der Steuereinrichtung 66 räumlich mehr Platz beanspruchen, als bei der Baugröße I gemäß Figur 4. Bei den Figuren 7 und 8 ist dies besonders gut zu erkennen. Auch bei diesen sehr schematischen Darstellungen kam es nicht auf die Darstellung des Gehäuses bzw. des Kompaktgerätes in allen Einzelheiten an, sondern nur auf die Darstellung der Unterschiede zum Gehäuse eines Kompaktgerätes der Baugröße I gemäß Figur 1 bzw. 4. In Figur 8 ist die Lage der seitlichen Abdeckplatte des Gehäuses mit einer unterbrochenen Linie 118 veranschaulicht.

Durch dieses erfindungsgemäße Gehäuse verringert sich der Montageaufwand und die Montagezeit erheblich, wodurch mittels vormontierter Komponenten der Steuereinrichtung die Endmontage ebenfalls sehr vereinfacht ausfällt.

## Patentansprüche

1. Gehäuse zur Aufnahme einer mit wärmeerzeugenden Bauelementen (92, 98) versehenen Steuereinrichtung (66), bestehend aus einem Druckguß-Gehäuse, umfassend eine Seitenwand (4), eine Rückwand (6), einen Boden (8), einen Deckel (10), eine vordere Strebe (12), einen Kühlkörper (16) und eine Luftführungseinrichtung (18), einer Abdeckplatte und einer Frontabdeckung, wobei die räumlich parallel zur Rückwand (6) verlaufenden Kühlrippen (14) des Kühlkörpers (16) in der Ebene der Seitenwand (4) enden und mit einem Schottblech (28) abgedeckt sind, und die dadurch gebildeten stirnseitig offenen Kühlkanäle (30) an der mit dem Boden (8) verbundenen Luftführungseinrichtung (18) beginnen und am Deckel (10) enden, wobei der Deckel (10) und der Boden (8) jeweils im vorderen Teil mit Durchbrüchen (50) für die Entwärmung des vorderen Gehäusebereichs und jeweils mit einem Durchbruch (48) zur Durchführung von Anschlußleitungen versehen sind, wobei die vordere Strebe (12) zwischen dem Boden (8) und dem Deckel (10) als seitliches Rahmenteil für die lösbare, eine seitliche Zugangsöffnung (2) des Gehäuses abdeckende Abdeckplatte und für die eine frontseitige Öffnung des Gehäuses verschließbare Frontabdeckung ausgebildet ist.

2. Gehäuse nach Anspruch 1, wobei die Rückwand (6) im oberen Teil mit einer Aufhängevorrichtung (22) und im unteren Teil mit einer Befestigungseinrichtung (24) versehen ist.

3. Gehäuse nach Anspruch 1, wobei zwischen dem Kühlkörper (16) und der Rückwand (6) des Druckguß-Gehäuses ein separater Kühlkanal (34) verläuft, in dem wenigstens eine Aufnahmevorrichtung (40) für zu kühlende Bauelemente (96) der Steuereinrichtung (66) hineinragen, und wobei der Boden (8) und der Deckel (10) des Gehäuses im Bereich des separaten Kühlkanals (34) jeweils mit Durchbrüchen (36, 38) versehen sind.

4. Gehäuse nach Anspruch 1, wobei neben der Luftführungseinrichtung (18) im Druckguß-Gehäuse eine Ausformung (20) angeordnet ist, die mit einem Durchbruch zur Durchführung von Anschlußleitungen versehen ist.

5. Gehäuse nach Anspruch 1, wobei im vorderen Gehäusebereich im Bereich der Durchbrüche (48) zur Durchführung von Anschlußleitungen jeweils zwei beabstandete Stege (42) auf der Innenseite der Seitenwand (4) des Druckguß-Gehäuses angeordnet sind.

6. Gehäuse nach Anspruch 1, wobei die Innenseite der Seitenwand (4) des Druckguß-Gehäuses mit Anschlußdome (44) für die Befestigung von Komponenten der Steuereinrichtung (66) versehen ist.

7. Gehäuse nach Anspruch 1, wobei die vordere Strebe (12) derartig ausgebildet ist, daß daran ein Drehscharnier der Frontabdeckung befestigt werden kann.

8. Gehäuse nach Anspruch 1, wobei im vorderen Gehäusebereich eine Elektronikbox (102) derart befestigt ist, daß deren frontseitige Öffnung räumlich parallel zur frontseitigen Öffnung des Gehäuses verläuft.

9. Gehäuse nach Anspruch 1, wobei parallel zur Abdeckplatte eine Elektrikbaugruppe (104) verläuft, die mit den wärmeerzeugenden elektrischen Bauelementen (86, 92, 98) elektrisch leitend verbunden ist, und wobei zwischen der Leiterplatte dieser Elektrikbaugruppe (104) und der Abdeckplatte eine Platte aus isolierendem Material angeordnet ist.

10. Gehäuse nach Anspruch 1, wobei parallel zum Durchbruch (48) zur Durchführung von Anschlußleitungen der Boden (8) und der Deckel (10) des Druckguß-Gehäuses jeweils eine Anschlagrippe (52) mit einer benachbarten Gewindebohrung (54) aufweist.

11. Gehäuse nach Anspruch 1, wobei der Boden (8) und der Deckel (10) des Druckguß-Gehäuses im Bereich des Kühlkörpers (16) und im Bereich der Luftführungseinrichtung (18) mit einer umlaufenden Auflageschulter (56) und einer Gewindebohrung (54) versehen sind.

12. Gehäuse nach Anspruch 1, wobei sich die Abdeckplatte auf eine umlaufende Schulter (62) entlang der Zugangsöffnung (2) des Gehäuses abstützt.

13. Gehäuse nach Anspruch 1, wobei als Befestigungseinrichtung (24) eine Anflanschung vorgesehen ist.

14. Gehäuse nach Anspruch 1, wobei als Aufhängevorrichtung (22) zwei Haken (26) vorgesehen sind, die in der Ebene der Rückwand (6) des Druckguß-Gehäuses liegen.

15. Gehäuse nach Anspruch 1, wobei ein Bedienfeld (90) in der Frontabdeckung untergebracht ist.

16. Gehäuse nach Anspruch 1, wobei die Abdeckplatte aus Metall ist.

17. Gehäuse nach Anspruch 1, wobei der Durchbruch im Boden (8) im Bereich der Luftführungseinrichtung (18) mit einer Gitterabdeckung (32) versehen ist.

18. Gehäuse nach Anspruch 1, wobei am Eingang der Luftführungseinrichtung (18) ein Lüfter (88) anortbar ist und dessen Anschlüsse in der nebengeordneten Ausformung (20) anortbar ist.
